# EUROPEAN PATENT APPLICATION

(11) **EP 3 357 662 A1**
(43) Date of publication of application: **08.08.2018**
(21) Application number: 18153560.0
(22) Date of filing: 26.01.2018
(51) Int. Cl.: B29C 45/00, H05K 9/00, C25D 5/02, B29L 31/34, B29L 31/36

(54) **ELECTRICAL STRUCTURAL MEMBER WITH AN ELECTROMAGNETIC SHIELDING, METHOD OF PRODUCING AN ELECTRICAL STRUCTURAL MEMBER WITH AN ELECTROMAGNETIC SHIELDING**

(30) Priority: 01.02.2017 DE 102017201616
(71) Applicant: TE Connectivity Germany GmbH, 64625 Bensheim (DE)
(72) Inventor: HELLER, Christian, 91555 Feuchtwangen (DE)
(74) Representative: Grünecker Patent- und Rechtsanwälte PartG mbB

(57) **Abstract**

An electrical structural member (1) with an electromagnetic shielding (2) is shown, wherein the structural member (1) comprises an injection moulded workpiece (3) and the electromagnetic shielding (2) is formed at least in sections by an electrically conductive coating (20) of the injection moulded workpiece (3). Furthermore, a method of producing such a structural member (1) is shown.

## Description

The invention relates to an electrical structural member with an electromagnetic shielding, and a method of producing an electrical structural member with an electromagnetic shielding.

Structural members of this type often comprise an injection moulded workpiece, around which a specifically shaped metal sheet is attached for electromagnetic shielding from interference radiation, for example.

However, such a procedure is complex.

The problem of the invention is to provide a solution which allows for a simpler production and at the same time sufficient shielding.

This is solved according to the invention in that the electromagnetic shielding is formed at least in sections by an electrically conductive coating of the injection moulded workpiece.

In a method according to the invention, an electrically conductive coating is applied on at least a part of an injection moulded workpiece.

By means of the solution according to the invention, the manufacturing and attachment of specifically shaped metal sheets can be dispensed with.

The invention can be further improved by the following advantageous further developments, which can be combined freely, and advantageous configurations.

The injection moulded workpiece can comprise a first component made from a first material and a second component made from a second material, wherein the first component is at least partially coated with an electrically conductive coating. Such a configuration enables a targeted coating in certain regions, for example if only certain parts are intended to be or allowed to be shielded.

In a method according to the invention, a first component made from a first material and a second component made from a second material can therefore be used for the production, wherein the first component or the first material can be coated with metal.

The second component can be uncoated. As a result, on the one hand a method step can be saved. On the other hand, it may be necessary that certain parts are not surrounded by a shielding, for example because radiation-emitting parts such as antennas are involved.

In a corresponding method, only the first component is at least partially coated, while the second component is not coated.

In a further advantageous configuration, the electrical structural member can comprise more than one injection moulded workpiece, wherein only one injection moulded workpiece is already coated or is being coated at least in sections.

Advantageously, at least a part and/or a component of the injection moulded workpiece comprises an activatable material which can be activated for applying an electrically conductive coating. An electrically conductive coat, for example made from metal, can be applied in an activated state, whereas such an application is not possible in a non-activated state.

In a corresponding method, an activatable material can therefore be used for a part or a component of the injection moulded piece.

In a subsequent step, a part which is to be coated can be activated before the electrically conductive coating is applied. An activator can be applied. This can be, for example, an adhesive agent which enables the electrically conductive coating to adhere to the injection moulded workpiece. The activator can remain on the injection moulded workpiece. Alternatively, an activator can be removed before coating in the coating step.

In the activation step, alternatively electromagnetic rays, for example, can be employed. These can for example alter the surface, e.g. oxidise, reduce or break bonds.

The part of the electrical structural member and/or of the injection moulded workpiece which is to be coated can be selectively activated. A geometric selection can take place, for example, by using a mask which has openings at parts which are to be coated and which covers the injection moulded workpiece at parts which are not to be coated. When using radiation, it can be specifically directed at parts which are to be coated.

Various possibilities are conceivable for carrying out the coating. For example, the injection moulded workpiece can be exposed to a liquid or a gas, for example by spraying, brushing, immersing or by a physical or chemical vapour deposition. If only one part of the injection moulded workpiece or only one component can be coated or is in an active state, only this part is coated. The injection moulded workpiece can also be subjected in its entirety to the coating process and does not have to be selectively coated. For example, the entire injection moulded workpiece can be immersed in a liquid. Non-activated parts and parts which cannot be coated are then not coated.

In an alternative configuration, the injection moulded workpiece can be selectively coated, for example once again via a geometric selection, e.g. with masks, or by a directed coating, e.g. with a directed ray, for example in the manner of an ink jet printer. This can enable a more precise selection of the region which is to be coated.

The injection moulded workpiece can comprise at least two components, wherein one component comprises an activatable material. The material or the component can be partially or fully activated in the finished state.

In order to achieve a complete shielding, the coating can form a shielding, which is closed on all sides, for the structural member. However, it can also have smaller holes or gaps which should, however, be smaller than 10% of the wavelength of a radiation which is to be shielded, for example.

In order to achieve a current flow and good shielding, different parts can be electrically conductively connected to each other.

In an advantageous configuration, the coating together with a further electrical shielding on the same or on a different structural member forms a shielding which is closed on all sides. For example, a complete shielding may only be achieved by a plug being mated together with a mating plug. The shieldings can each be incomplete in a non-mated state.

The electrically conductive coating can have at least two layers. The two layers can consist of different materials, for example in order to achieve a certain resistance in a targeted manner.

In order to achieve a good shielding effect, the electromagnetic shielding or the electrically conductive coating can be present on an outer side of the structural member or of the injection moulded workpiece.

In order to protect the coat, further coats can be present on top of the electrically conductive coating, which offer mechanical or chemical protection. These can be electrically insulating and made, for example, from an oxide or a plastic.

In order to achieve a good shielding, the electrically conductive coat can comprise in particular a metal.

The electromagnetic shielding or the electrically conductive coating can surround an inner space for receiving electrical structural members.

The structural member can in particular be a connector or a plug, or a structural member in which electrical conductors of otherwise shielded cables are connected. By means of the electromagnetic shielding, shielding is achieved also in the region of the connection.

The injection moulded workpiece can be a housing or a terminal block. By means of the solution according to the invention, further parts are saved here.

The injection moulded workpiece can comprise a plastic. This can be easily reshaped.

In order to achieve sufficient shielding, the electrically conductive coating can have a thickness of between 1 and 500 µm.

The injection moulded workpiece can be an extra shield part. In such a configuration, a metal sheet which has been produced previously can be replaced by a coated shield part such that the production is easier and more economical.

Hereinafter, the invention is explained in greater detail by way of example using advantageous configurations with reference to the drawings. The advantageous further developments and configurations illustrated in this instance are each independent of each other and can be freely combined with each other, depending on how this is necessary in the case of application.

In the drawings:
Fig. 1 shows a schematic cross-sectional view of a first embodiment of an electrical structural member;
Fig. 2 shows a schematic perspective view of a second embodiment of an electrical structural member;
Figs. 3A, 3B, 3C show three steps in the production of a third embodiment of an electrical structural member;
Fig. 4 shows a schematic sectional view of a fourth embodiment in a detail view;
Figs. 5A, 5B, 5C, 5D show steps of a method of producing an embodiment of an electrical structural member;
Fig. 6 shows a schematic sectional view of a sixth embodiment of an electrical structural member;
Fig. 7A, 7B, 7C shows three steps of a method of producing a seventh embodiment of an electrical structural member.

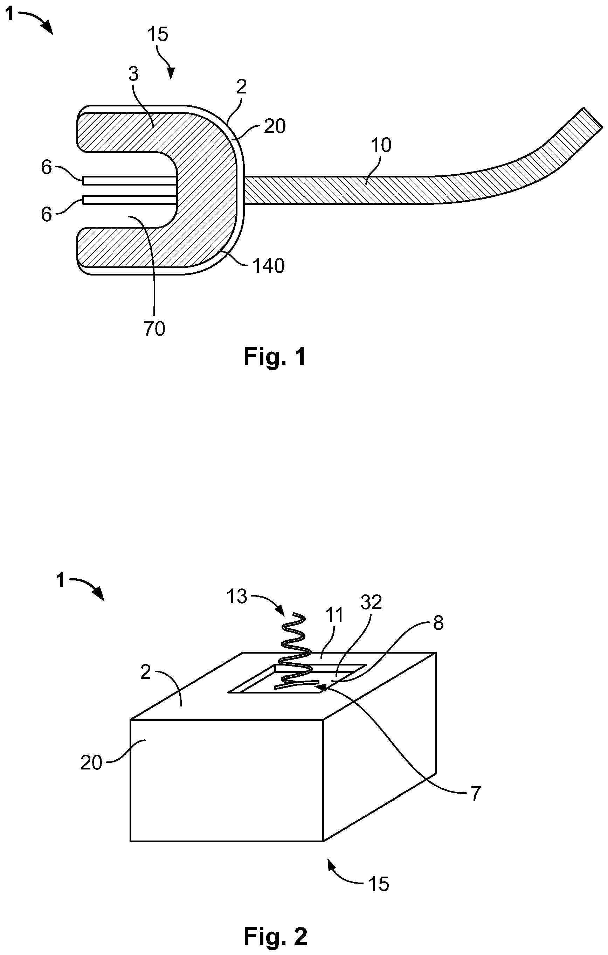

Fig. 1 shows a first embodiment of an electrical structural member 1. The electrical structural member 1 in the form of a plug comprises an injection moulded workpiece 3 in which two contact elements 6 for producing an electrical contact with a mating plug which is not shown are arranged. Electrical currents are fed through a cable 10.

In order to shield the connection region between the plug and the mating plug from electromagnetic radiation, for example, the injection moulded workpiece 3 is surrounded in one part 140 by an electromagnetic shielding 2. In the shown exemplary embodiment, the electromagnetic shielding 2 is formed by an electrically conductive coating on the injection moulded workpiece 3.

The electromagnetic shielding 2 is located on an outer side 15 of the injection moulded workpiece 3. Together with a corresponding shielding on the mating plug, an inner space 70 is shielded.

The electrically conductive coating 20 can be connected to a shielding element of the cable 10 via a connecting element which is not shown, for example in order to set the electrically conductive coating at ground potential.

In Fig. 2, a second embodiment of an electrical structural member 1 is shown, in which an electromagnetic shielding 2, which is formed by an electrically conductive coating 20, covers almost the entire outer side 15 of the electrical structural member 1 or of the injection moulded workpiece 3. A gap is only present in the region of an opening 8 on the upper side 11. This gap serves to emit electromagnetic radiation 13 by means of an antenna 7. Such a configuration can be achieved, for example, by a second component 32 which cannot be coated being used in the region of the antenna 7. In the other regions, a first component 31 is used which can be coated and which is covered by the electrically conductive coating 20.

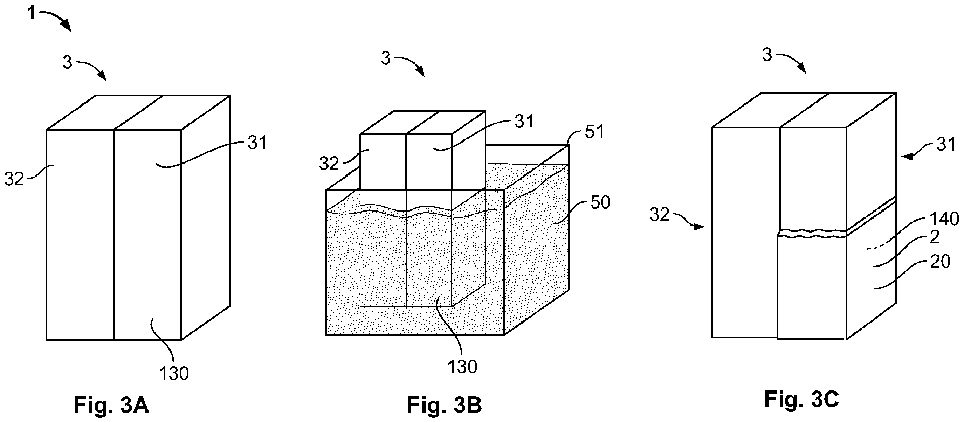

In Figures 3A, 3B, 3C, three steps of a method are shown with which an injection moulded workpiece 3 is at least partially coated with an electrically conductive coating 20.

The injection moulded workpiece 3 illustrated in Fig. 3A consists of a first component 31 and a second component 32. The first component 31 comprises a material which can be coated, whereas the second component 32 consists of a material which cannot be coated. A part 130 which is to be coated is part of the first component 31. Electrical elements, which can be part of the electrical structural member 1, are not illustrated for the sake of simplicity, but can be located at different points on or in the injection moulded workpiece or can be covered or supported by it.

In the method step illustrated in Fig. 3B, the injection moulded workpiece 3 is at least partially immersed in a solution 50 which is located in a container 51. As a result, an electrically conductive coating is deposited on the component 31. By contrast, the second component 30 remains uncoated.

In Fig. 3C, the fabricated injection moulded workpiece 3 is shown with a partial coating 20 in a part 140 on the first component 31 of the injection moulded workpiece 3.

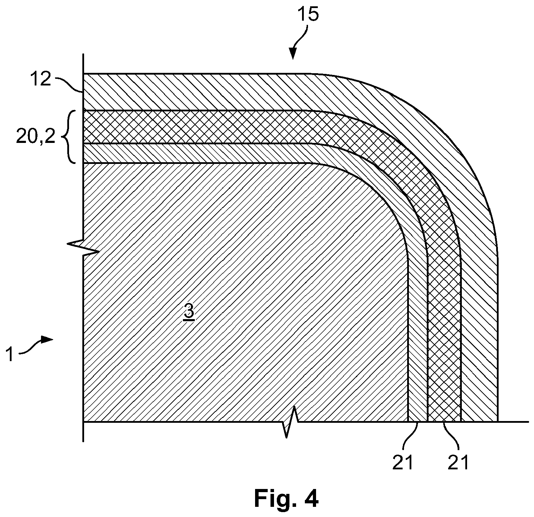

Fig. 4 shows a detail of a cross-section through a fifth embodiment. An injection moulded workpiece 3 has an electromagnetic shielding 2 which consists of two electrically conductive layers 21. These two layers 21 can have different thicknesses and/or consist of different materials. In particular, they can comprise metals. The injection moulded workpiece 3, in turn, preferably consists of a plastic.

A layer 21, located further on the inside, can be an adhesive agent between the plastic of the injection moulded workpiece 3 and a layer 21 located further on the outside. The layer 21 located further on the outside can achieve a better shielding effect than the layer 21 located further on the inside, but cannot be attached to the plastic without it.

Outside the two electrically conductive layers 21 or the electrically conductive coating 20, another protective coat 12 is present which protects the two layers 21, for example, from mechanical or chemical external influences. This protective coat 12 can consist of an insulating material such as plastic or a metal oxide.

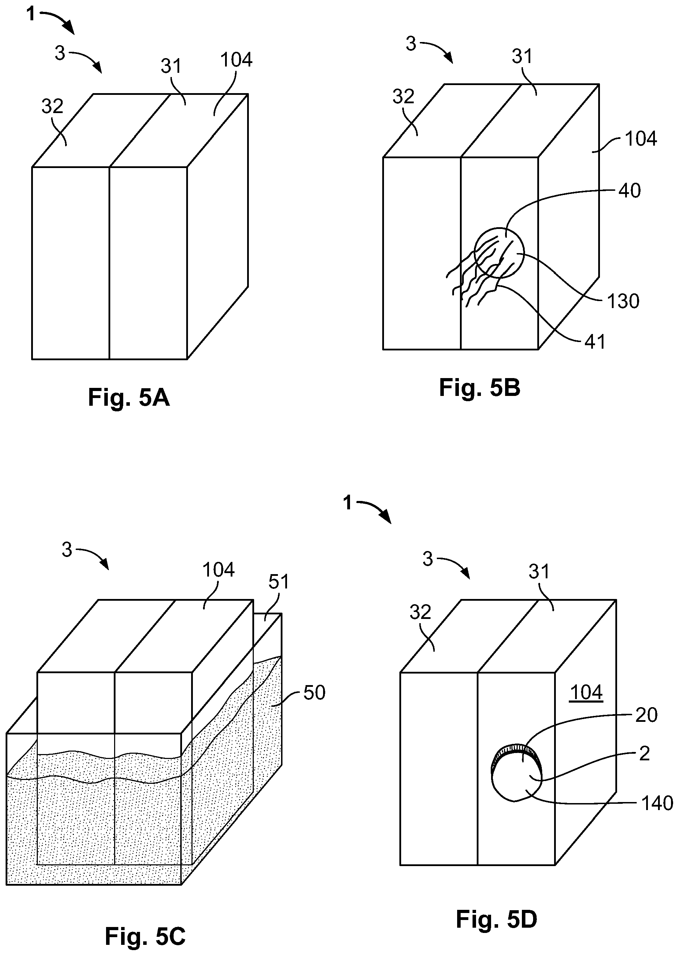

In Figures 5A, 5B, 5C and 5D, different steps of a method of producing a fifth embodiment of an electrical structural member 1 are shown.

As illustrated in Fig. 5, the injection moulded workpiece 3 again consists of a first component 31 and a second component 32. The first component 31 comprises an activatable material 104, in other words a material which becomes able to be coated with the electrically conductive coating by means of activation. The second component 32 does not have to be able to be coated nor be activatable. A part of the first component 31, i.e. a part 130 which is to be coated or an activation region 40, is activated by an activation radiation 41. In the activation region 40 shown in Fig. 5B, the first component 31 therefore has become able to be coated, whereas it remains unable to be coated in the other region.

In the coating step shown in Fig. 5C, which again comprises the at least partial immersion of the injection moulded workpiece 3 in a solution 50 in a container 51, only the activation region 40 is coated with the electrically conductive coating 20. The result can be seen in Fig. 5D. A large part of the electrical structural member 1 is uncoated and only a small part 140 comprises an electromagnetic shielding 2 in the form of the electrically conductive coating 20.

In the procedure shown, the structural member 1 can of course also be completely immersed in the solution.

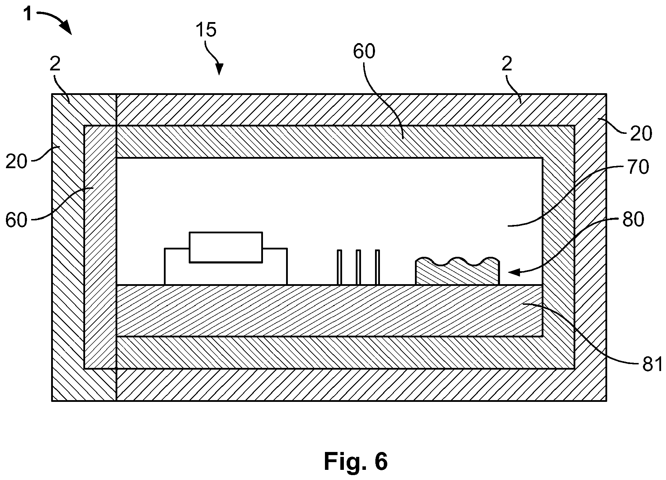

In Fig. 6, a sixth embodiment is shown. The electrical structural member 1 comprises a support 81 on which electrical elements 80 such as resistors, processors or the like can be arranged.

Two shielding elements 60 form an inner space 70 in which the support 81 and the electrical elements 80 are arranged. The shielding elements 60 each have an electromagnetic shielding 2 in the form of an electrically conductive coating 20. The coatings 20 together form a shielding 90, which is closed on all sides, for the structural member 1 which neither allows electromagnetic radiation to pass through from the outside inwardly nor vice versa.

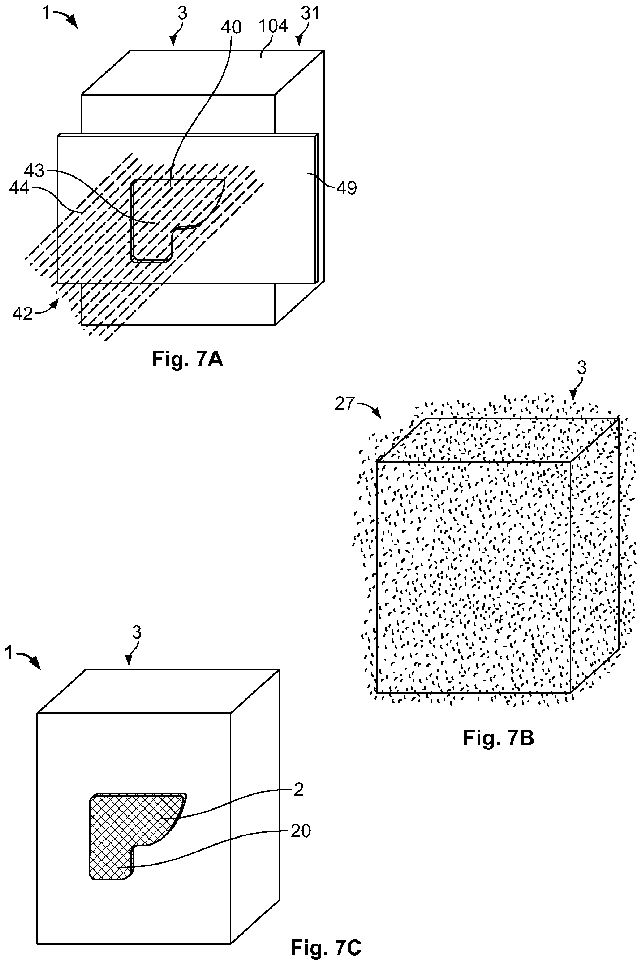

In Figures 7A, 7B, 7C, a method of producing a seventh embodiment of an electrical structural member 1 with an electromagnetic shielding 2 is shown.

In the method step shown in Fig. 7A, the injection moulded workpiece 3, which in this case consists of only one single component 31 which is activatable, is activated by rays 42 made from an activation material 44 in the region of a hole 43 in a mask 49. The activation region 40 on the injection moulded workpiece 3 is defined by the hole 43. This therefore is a selective activation in the activation region 40 by means of the mask 49.

After the mask 49 is removed and the activation material 44 is optionally washed off in the activation region 40, as shown in Fig. 7B, the workpiece 3 is exposed to a gas atmosphere 27 which results in the workpiece 3 being coated in the activation region 40, as can be seen in Fig. 7C.

Similarly to the method shown in Figures 7A, 7B and 7C, coating can also be carried out in a selective manner, e.g. by applying a material through a mask 49. A selective application in the manner of an ink jet printer is also possible, both for an activation step and for a coating step.

Alternatively to the shown coating steps, other methods can also be used, for example brushing with a liquid, gel-like or paste-like material.

### List of reference numbers

- 1: Electrical structural member
- 2: Electromagnetic shielding
- 3: Injection moulded workpiece
- 6: Contact element
- 7: Antenna
- 8: Opening
- 10: Cable
- 11: Upper side
- 12: Protective coat
- 13: Radiation
- 15: Outer side
- 20: Electrically conductive coating
- 21: Electrically conductive layer
- 27: Gas atmosphere
- 31: First component
- 32: Second component
- 40: Activation region
- 41: Activation radiation
- 42: Rays
- 43: Hole
- 44: Activation material
- 49: Mask
- 50: Solution
- 51: Container
- 60: Shielding element
- 70: Inner space
- 80: Electrical elements
- 81: Support
- 90: Shielding closed on all sides
- 104: Activatable material
- 130: Part to be coated
- 140: Part

## Claims

1. An electrical structural member (1) with an electromagnetic shielding (2), wherein the structural member (1) comprises an injection moulded workpiece (3), **characterised in that** the electromagnetic shielding (2) is formed at least in sections by an electrically conductive coating (20) of the injection moulded workpiece (3).

2. The electrical structural member (1) according to Claim 1, wherein the injection moulded workpiece (3) comprises a first component (31) made from a first material and a second component (32) made from a second material, and the first component (31) is at least partially coated with an electrically conductive coating (20).

3. The electrical structural member (1) according to Claim 2, wherein the second component (32) is uncoated.

4. The electrical structural member (1) according to any one of Claims 1 to 3, wherein at least a part (140) of the injection moulded workpiece (3) comprises an activatable material (104) which can be activated for applying an electrically conductive coating (20).

5. The electrical structural member (1) according to any one of Claims 1 to 4, wherein the injection moulded workpiece (3) comprises at least two components (31, 32) and at least a component (31) comprises an activatable material (104).

6. The electrical structural member (1) according to any one of Claims 1 to 5, wherein the electrically conductive coating (20) forms a shielding (90), which is closed on all sides, for the structural member (1).

7. The electrical structural member (1) according to any one of Claims 1 to 6, wherein the electrically conductive coating (20) comprises at least two electrically conductive layers (21).

8. A method of producing an electrical structural member (1) with an electromagnetic shielding (2), wherein the structural member (1) comprises an injection moulded workpiece (3), **characterised in that** it comprises a step in which an electrically conductive coating (20) is applied on at least a part (140) of an injection moulded workpiece.

9. The method according to Claim 8, wherein the part (130) which is to be coated is activated for applying an electrically conductive coating (20) before the electrically conductive coating (20) is applied.

10. The method according to one of Claims 8 or 9, wherein the part (130) of the structural member (1) which is to be coated is selectively activated.

11. The method according to any one of Claims 8 to 10, wherein the part (140) of the structural member (1) is selectively coated.

12. The method according to any one of Claims 8 to 11, wherein the entire injection moulded workpiece (3) undergoes an activation step.

13. The method according to any one of Claims 8 to 12, wherein the activation step and/or the coating step comprises an immersion in a liquid (50), at least in sections.
